# EUROPÄISCHE PATENTANMELDUNG

(11) **EP 4 704 272 A1**
(43) Veröffentlichungstag der Anmeldung: **04.03.2026**
(21) Anmeldenummer: 25194924.4
(22) Anmeldetag: 08.08.2025
(51) Int. Cl.: H02B 1/56, H05K 7/20, F25B 39/02

(54) **KLIMATISIERUNGSANORDNUNG MIT WÄRMELEITUNGSWÄRMETAUSCHER**

(30) Priorität: 27.08.2024 DE 202024104817 U
(71) Anmelder: Pfannenberg GmbH, 21035 Hamburg (DE)
(72) Erfinder: Wagner, Torben, 21035 Hamburg (DE)
(74) Vertreter: RGTH

(57) **Zusammenfassung**

Um eine Klimatisierungsanordnung für einen Schaltschrank bereitzustellen, welche einen explosionssicheren Betrieb der Klimatisierungsanordnung mit einem brennbaren bzw. hoch entflammbaren Kältemittel ermöglicht, wird eine Klimatisierungsanordnung (100) für einen Schaltschrank (21) vorgeschlagen, umfassend ein Gehäuse (22) mit einem schaltschrankseitigen Gehäusebereich (A) und einem außenseitigen Gehäusebereich (B), umfassend eine zwischen dem schalt-schrankseitigen Gehäusebereich (A) und dem außenseitigen Gehäusebereich (B) angeordnete Trennwand (13), welche den schaltschrankseitigen Gehäusebereich (A) und den außenseitigen Gehäusebereich (B) fluidisch voneinander trennt, und umfassend
einen sich durch die Trennwand (13) hindurcherstreckenden ersten Wärmetauscher (10), wobei der erste Wärmetauscher (10) ein Luft-Flüssigkeits-Wärmetauscher ist, mit einem im außenseitigen Gehäusebereich (B) angeordneten Verdampferabschnitt (15) und einem mit dem Verdampferabschnitt (15) thermisch gekoppelten, im schalt-schrankseitigen Gehäusebereich (A) angeordneten Wärmeaufnahmeabschnitt (14) zur Aufnahme der Wärme aus dem schaltschrankseitigen Gehäusebereich (A) und zur Weiterleitung der Wärme an den Verdampferabschnitt (15) mittels Wärmeleitung, wobei im außenseitigen Gehäusebereich (B) ein, insbesondere ein brennbares und/oder toxisches Kältemittel aufweisender, Kältemittelkreis (12) angeordnet ist, derart, dass die an den Verdampferabschnitt (15) weitergeleitete Wärme aus dem schaltschrankseitigen Gehäusebereich (A) an den Kältemittelkreis übertragbar ist.

## Beschreibung

Die vorliegende Erfindung betrifft eine Klimatisierungsanordnung sowie einen Schaltschrank aufweisend eine solche Klimatisierungsanordnung.

### Technologischer Hintergrund

Ein Schaltschrank der hier angesprochenen Art nimmt eine Vielzahl von elektronischen Komponenten auf, die zur Steuerung einer verfahrenstechnischen Anlage, einer Werkzeugmaschine oder einer sonstigen Fertigungseinrichtung ausgebildet sind. Zu den typischerweise verbauten elektronischen Komponenten zählen insbesondere Stromleitungen, Klemmen, Widerstände, Kondensatoren, Dioden, Transistoren, Induktivitäten, integrierte Schaltkreise, Relais, Sensoren und vieles mehr. Beim bestimmungsgemäßen Betrieb eines solchen Schaltschranks entsteht Wärme, die zur Aufrechterhaltung der dauerhaften Funktionsfähigkeit der elektrischen Komponenten effektiv abzuführen ist. Hierfür ist in einem herkömmlichen Schaltschrank häufig ein Wärmetauscher mit einem Rohrleitungssystem verbaut, das zur Leitung eines Kältemittels ausgebildet ist und mehrere Rohrstücke sowie mehrere Rohrbögen besitzt, wobei die Rohrbögen jeweils zwei Endabschnitte zweier Rohrstücke fluidleitend miteinander verbinden. Insofern bildet das Rohrleitungssystem eine Rohrschlange, in der ein Kältemittel zirkuliert, das innerhalb des Schaltschranks Wärme aufnimmt und die Wärme außerhalb des Schaltschranks abführt. Zur effektiven Wärmeabfuhr wird in einem Innenkreis des Schaltschranks eine Luftströmung erzeugt, die den Wärmetauscher beaufschlagt. Dieser Innenkreis ist vom Außenkreis abgeschirmt, sodass keine Gase vom Außenkreis in den Innenkreis des Schaltschranks gelangen können.

Als Kältemittel sind nach dem Stand der Technik insbesondere fluorierte Kältemittel mit Treibhauspotential bekannt, die in Bezug auf die Wärmeabfuhr zwar aus thermodynamischen Gründen vorteilhaft sind, allerdings im Leckagefall an die Umwelt abgegeben werden, was mit negativen Auswirkungen auf das Klima verbunden ist. Besonders leckageanfällige Bereiche eines solchen Rohrleitungssystems sind beispielsweise Rohrbögen, die eine Krümmung von mehr als 90° aufweisen, und Verbindungsstellen, insbesondere Lötstellen, zwischen den Rohrbögen und den Rohrabschnitten. Die Verwendung von fluorierten Kältemitteln ist daher auf absehbare Zeit einzustellen, weshalb zukünftig auf alternative Kältemittel zurückgegriffen werden muss.

Alternative Kältemittel, die aus thermodynamischen Gründen in sinnvoller Weise verwendbar sind, sind in der Regel brennbar bzw. hoch entflammbar oder weisen hohe Betriebsdrücke bei transkritischem Betrieb auf. Um derartige Kältemittel in der Schaltschrankklimatisierung sicher und richtlinienkonform einsetzen zu können, ist eine sichere Ausgestaltung, insbesondere des Innenkreises des Schaltschranks, notwendig. Hierbei muss auch im Leckagefall sichergestellt werden, dass durch austretendes Kältemittel, insbesondere im Bereich des Verdampfers, keine explosive Atmosphäre entsteht, weil diese durch ein elektronisches Bauteil im Schaltschrank gezündet werden könnte.

### Darstellung der Erfindung: Aufgabe, Lösung, Vorteile

Der vorliegenden Erfindung liegt die Aufgabe zugrunde, eine Klimatisierungsanordnung für einen Schaltschrank bereitzustellen, welche einen explosionssicheren Betrieb der Klimatisierungsanordnung mit einem brennbaren bzw. hoch entflammbaren Kältemittel ermöglicht.

Zur Lösung der der Erfindung zugrunde liegenden Aufgabe wird eine Klimatisierungsanordnung für einen Schaltschrank vorgeschlagen umfassend ein Gehäuse mit einem schaltschrankseitigen Gehäusebereich und einem außenseitigen Gehäusebereich, umfassend eine zwischen dem schaltschrankseitigen Gehäusebereich und dem außenseitigen Gehäusebereich angeordnete Trennwand, welche den schaltschrankseitigen Gehäusebereich und den außenseitigen Gehäusebereich fluidisch voneinander trennt, und umfassend einen sich durch die Trennwand hindurcherstreckenden ersten Wärmetauscher, wobei der erste Wärmetauscher ein Luft-Flüssigkeits-Wärmetauscher ist, mit einem im außenseitigen Gehäusebereich angeordneten Verdampferabschnitt und mit einem mit dem Verdampferabschnitt thermisch gekoppelten, im schaltschrankseitigen Gehäusebereich angeordneten Wärmeaufnahmeabschnitt zur Aufnahme der Wärme aus dem schaltschrankseitigen Gehäusebereich und zur Weiterleitung der Wärme an den Verdampferabschnitt mittels Wärmeleitung, wobei im außenseitigen Gehäusebereich ein, insbesondere ein brennbares und/oder toxisches Kältemittel aufweisender, Kältemittelkreis angeordnet ist, derart, dass die an den Verdampferabschnitt weitergeleitete Wärme aus dem schaltschrankseitigen Gehäusebereich an den Kältemittelkreis übertragbar ist.

Bei dem ersten Wärmetauscher handelt es sich erfindungsgemäß um einen Luft-Flüssigkeits-Wärmetauscher. Das bedeutet, dass der erste Wärmetauscher Wärme aus einen Luftvolumen entnimmt und an eine Flüssigkeit, insbesondere das Kältemittel, überträgt. Die Aufnahme der Wärme aus der Luft erfolgt dabei insbesondere in dem schaltschrankseitigen Gehäusebereich, während die Abgabe der Wärme an die Flüssigkeit in dem außenseitigen Gehäusebereich erfolgt.

Innerhalb des ersten Wärmetauschers, insbesondere vom Wärmeaufnahmeabschnitt zum Verdampferabschnitt, erfolgt die Weiterleitung der Wärmeenergie der Luft, insbesondere ausschließlich, über Wärmeleitung. Insbesondere ist innerhalb des Wärmeaufnahmeabschnitts des ersten Wärmetauschers kein Kältemittel bzw. kein Kältefluid angeordnet. Ferner findet bevorzugt innerhalb des Wärmeaufnahmeabschnitts des ersten Wärmetauschers keine Wärmeströmung und keine Wärmestrahlung statt. In dem ersten Wärmetauscher erfolgt die Weiterleitung der Wärme von der Luft in dem schaltschrankseitigen Gehäusebereich zu dem Kältemittel bzw. der Flüssigkeit in dem außenseitigen Gehäusebereich, daher insbesondere mittels Wärmeleitung in einem festen Material ohne Materialtransport. Der Wärmeaufnahmeabschnitt des ersten Wärmetauschers ist somit insbesondere passiv. Ein konvektiver Wärmeübergang ohne Stoffaustausch (d.h. ohne Materialtransport) kann bei der Übertragung der Wärme aus der Luft im schaltschrankseitigen Gehäusebereich an den Wärmeaufnahmeabschnitt und bei der Abgabe der Wärme von dem Verdampferabschnitt an ein Kältemittel bzw. Luft im außenseitigen Gehäusebereich erfolgen.

Dadurch, dass die Wärmeübertragung von dem schaltschrankseitigen Gehäusebereich zu dem außenseitigen Gehäusebereich im Wärmeaufnahmeabschnitt und dem Verdampferabschnitt ausschließlich mittels Wärmeleitung erfolgt, kann vorteilhaft auf brennbares Kältemittel im schaltschrankseitigen Gehäusebereich verzichtet werden, wodurch die Explosionsgefahr vorteilhaft minimiert bzw. nahezu vollständig ausgeschlossen werden kann. Ein Wärmeübertrager, welcher Wärme ausschließlich durch Wärmeleitung überträgt, kann zudem auf einfache und kostengünstige Weise hergestellt werden, da diese in der Regel einen einfachen Aufbau aufweisen.

Bevorzugt ist der Wärmeaufnahmeabschnitt des ersten Wärmetauschers aus einem Vollmaterial gebildet, das heißt der Wärmeaufnahmeabschnitt weist insbesondere keine inneren, geschlossenen Hohlräume auf.

Der schaltschrankseitige Gehäusebereich ist bevorzugt zu dem Schaltschrank hin geöffnet bzw. ist fluidisch mit diesem verbunden, sodass durch die Komponenten des Schaltschranks erwärmte Luft zu dem Wärmeaufnahmeabschnitt des ersten Wärmetauschers gelangen kann. Bevorzugt kann wenigstens eine Fördereinrichtung, beispielsweise ein Lüfter bzw. ein Ventilator, vorgesehen sein, um die erwärmte Luft des Schaltschranks hin zu dem Wärmeaufnahmeabschnitt zu fördern.

Der außenseitige Gehäusebereich ist bevorzugt zur Umgebung hin geöffnet oder kann zur Umgebung hin geöffnet werden, um die Wärme, welche über den ersten Wärmetauscher in den außenseitigen Gehäusebereich bzw. den Kältemittelkreis in dem außenseitigen Gehäusebereich geleitet wurde, zur Umgebung hin abzuführen. Hierfür kann beispielsweise in dem Gehäuse des außenseitigen Gehäusebereichs eine Öffnung vorgesehen sein. Ferner bevorzugt kann in dieser Öffnung ein Ventilator, Lüfter, Austrittsfilter, etc. angeordnet sein.

Bevorzugt verläuft der Kältemittelkreis durch den Verdampferabschnitt. Dadurch wird eine thermische Kopplung zwischen dem Verdampfer und dem Kältemittel in dem Kältemittelkreis realisiert, sodass die Wärme von dem Verdampferabschnitt mittels Wärmeleitung an das Kältemittel übertragen werden kann. Beispielsweise kann der Kältemittelkreis eine oder mehrere Leitungen für das Kältemittel aufweisen, welche abschnittsweise thermisch mit dem Verdampfer gekoppelt ist oder sind. Ferner kann der Kältemittelkreis einen weiteren Wärmetauscher aufweisen, über welche die Wärme von dem Kältemittel an die Umgebung übertragen werden kann.

Bevorzugt sind der Verdampferabschnitt und der Wärmeaufnahmeabschnitt einstückig ausgebildet. Dadurch ergibt sich ein besonders einfacher Aufbau. Insbesondere sind der Verdampferabschnitt und der Wärmeaufnahmeabschnitt aus dem gleichen Material gefertigt, welches insbesondere eine hohe Wärmeleitfähigkeit aufweist. Insbesondere sind der Verdampferabschnitt und der Wärmeaufnahmeabschnitt in einem einzigen Bauteil realisiert.

Alternativ können der Wärmeaufnahmeabschnitt und der Verdampferabschnitt bevorzugt zwei separate Bauteile darstellen, welche insbesondere mittels Verbindungsmittel miteinander verbunden sind. Der Wärmeaufnahmeabschnitt und der Verdampferabschnitt können aus dem gleichen und unterschiedlichen Materialien hergestellt sein. Die Materialen können beispielsweise Aluminium, Stahl, Kupfer und/oder ein keramischer Werkstoff sein.

Bevorzugt ist der erste Wärmetauscher in einer Öffnung in der Trennwand angeordnet, wobei der erste Wärmetauscher die Öffnung, insbesondere fluidisch, dicht abschließt. Ferner kann bevorzugt eine Dichtungseinrichtung zwischen dem ersten Wärmetauscher und der Trennwand angeordnet sein.

Bevorzugt ist bzw. sind der Wärmeaufnahmeabschnitt und/oder der Verdampferabschnitt durch einen flächigen Abschnitt des ersten Wärmetauschers gebildet, wobei sich der flächige Abschnitt über im Wesentlichen eine gesamte Öffnungsfläche einer Öffnung in der Trennwand erstreckt. Die flächigen Abschnitte stellen vorteilhaft eine große Oberfläche für eine effektive Wärmeübertragung bereit.

Insbesondere weist der erste Wärmetauscher einen, insbesondere flächigen, Grundkörper auf, welcher bevorzugt die flächigen Abschnitte aufweist.

Bevorzugt ist der Grundkörper des ersten Wärmetauschers im Wesentlichen plattenförmig ausgebildet. Durch die Plattenform wird vorteilhaft eine große Oberfläche zur Wärmeübertragung bereitgestellt, während gleichzeitig die Wärmeleitung nur durch kurze Materialabschnitte stattfinden muss, wodurch die Effizienz der Wärmeübertragung von dem schaltschrankseitigen Gehäusebereich in den außenseitigen Gehäusebereich zusätzlich erhöht wird.

Bevorzugt erstreckt sich der, insbesondere flächig ausgebildete, Grundkörper des ersten Wärmetauschers im Wesentlichen parallel zur Trennwand. Insbesondere erstreckt sich der Grundkörper des ersten Wärmetauschers bzw. dessen flächigen Abschnitte parallel zu der Öffnung bzw. der Öffnungsfläche in der Trennwand.

Bevorzugt bildet eine erste Seite des flächigen Grundkörpers den Wärmeaufnahmeabschnitt und ist zum schaltschrankseitigen Gehäusebereich hin orientiert.

Bevorzugt bildet eine zweite, der ersten Seite des flächigen Grundkörpers gegenüberliegende Seite des ersten Wärmetauschers den Verdampferabschnitt und ist zum außenseitigen Gehäusebereich hin orientiert.

Bevorzugt bilden jeweils eine gesamte Oberfläche der ersten bzw. der zweiten Seite Bereiche des Wärmeaufnahmeabschnitts bzw. des Verdampferabschnitts. Insbesondere ist der erste Wärmetauscher somit durch eine Platte gebildet, welche im Bereich dessen umlaufender Außenkante in die Öffnung in der Trennwand eingesetzt ist. Die erste Seite ist vollständig dem schaltschrankseitigen Gehäusebereich zugewandt und die zweite Seite ist vollständig dem außenseitigen Gehäusebereich zugewandt. Der erste Wärmetauscher kann mit anderen Worten als ein Abschnitt der Trennwand betrachtet werden.

Bevorzugt weist der erste Wärmetauscher an dem Wärmeaufnahmeabschnitt eine Vielzahl von Wärmeübertragungskörper, insbesondere Kühlrippen, auf, welche sich in den schaltschrankseitigen Gehäusebereich hinein erstrecken. Sind die Wärmeübertragungskörper als Kühlrippen ausgestaltet, sind die Kühlrippen bevorzugt parallel zueinander angeordnet. Alternativ können die Wärmeübertragungskörper Kühlpins sein oder jede andere geeignete Form zur effektiven Wärmeübertragung aufweisen. Die Wärmeübertragungskörper können einstückig mit dem Wärmeaufnahmeabschnitt ausgebildet sein oder die Wärmeübertragungskörper und der Wärmeaufnahmeabschnitt können separate Elemente darstellen. Bevorzugt können die Wärmeübertragungskörper Aluminium, Stahl, Kupfer und/oder einen keramischen Werkstoff umfassen oder aus Aluminium, Stahl, Kupfer und/oder einem keramischen Werkstoff bestehen.

Bevorzugt erstrecken sich die Wärmeübertragungskörper über den gesamten Wärmeaufnahmeabschnitt.

Bevorzugt ist der Kältemittelkreislauf ausschließlich in dem außenseitigen Gehäusebereich angeordnet. Insbesondere sind sämtliche Kältemittelleitungen und Anschlüsse für die Kältemittelleitungen in dem außenseitigen Gehäusebereich angeordnet. Ferner liegen insbesondere alle leckagegefährdeten Bereiche bzw. Abschnitte wie Rohrbögen oder Rohrverbindungsstellen der Kältemittelleitungen im äußeren Luftstrom. Entsprechend ist der Kältemittelkreislauf nicht im schaltschrankseitigen Gehäusebereich angeordnet und insbesondere befindet sich kein Kältemittel im schaltschrankseitigen Gehäusebereich. So kann vermieden werden, dass brennbares Kältemittel in den Schaltschrank gelangt. Der Wärmetauscher kann hinsichtlich der leckagegefährdeten Bereiche als sicher angesehen werden. Somit ist der Wärmetauscher unabhängig vom Schaltschrankinnenvolumen einsetzbar. Teure Sicherheitsvorrichtungen, wie z.B. zur Gasdetektion, müssen daher nicht im Schaltschrank vorgesehen werden. Bevorzugt ist der Kältemittelkreislauf ein aktiver Kreislauf. Entsprechend weist der Kältemittelkreislauf bevorzugt Komponenten wie einen Verflüssiger, einen Verdampfer, einen Verdichter und/oder Expansionsmittel auf.

Bevorzugt umfasst der Verdampferabschnitt wenigstens einen Kältemittelführungsabschnitt, wobei der Kältemittelführungsabschnitt thermisch mit dem Wärmeaufnahmeabschnitt des ersten Wärmetauschers gekoppelt ist. Insbesondere ist der Kältemittelführungsabschnitt an den Kältemittelkreis gekoppelt bzw. koppelbar. Bevorzugt weist der Kältemittelführungsabschnitt das Kältemittel auf bzw. wird von dem Kältemittel durchströmt. Der Kältemittelführungsabschnitt kann somit einen Teil bzw. Abschnitt des Kältemittelkreises bilden. Die thermische Kopplung zwischen dem Kältemittelführungsabschnitt und dem Wärmeaufnahmeabschnitt erfolgt insbesondere mittels Wärmeleitung. Der Kältemittelführungsabschnitt kann bevorzugt durch ein Bauteil gebildet sein, beispielsweise eine oder mehrere Rohrabschnitte oder kann einen Bereich innerhalb des Verdampferabschnitts darstellen, welcher von dem Kältemittel durchströmt werden kann.

Bevorzugt umfasst der Kältemittelkreislauf Propan als Kältemittel. Alternativ kann der Kältemittelkreislauf andere brennbare oder explosionsgefährdete Kältemittel aufweisen. Dadurch, dass der Kältemittelkreislauf und somit das Kältemittel ausschließlich im außenseitigen Gehäusebereich angeordnet sind, kann vorteilhaft die Explosionsgefahr, welche durch einen potentiellen Kontakt des Kältemittel mit den Schaltschranckomponenten ausgeht, minimiert werden.

Bevorzugt ist der Kältemittelführungsabschnitt wenigstens eine Kältemittelleitung, wobei der Kältemittelführungsabschnitt bevorzugt eine Vielzahl von separaten Kältemittelleitungen aufweist. Die Wärme kann somit von dem Verdampferabschnitt an das Kältemittel in den Kältemittelleitungen bzw. den Kältemittelleitungsabschnitten übertragen werden und dann mittels des Kältemittelkreises in die Umgebung abgeführt werden. Die Kältemittelleitungen können insbesondere Rohre bzw. Rohrabschnitte sein.

Bevorzugt kann die Kältemittelleitung bzw. können die Kältemittelleitungen durch eine oder mehrere Bohrungen im Verdampferabschnitt bzw. dem Material des Verdampferabschnitts ausgebildet sein. Die Kältemittelleitungen sind gemäß dieser Ausgestaltung nicht durch ein separates Bauteil, wie etwa Rohre, gebildet, sondern durch eine Ausnehmung bzw. einen Bereich innerhalb des Verdampferabschnitts. An die Bohrungen können Kältemittelleitungen angeschlossen werden, welche außerhalb des Verdampferabschnitts bzw. des ersten Wärmetauchers verlaufen und Teil des Kältemittelkreises sind.

Ferner kann die wenigstens eine Kältemittelleitung gebildet werden durch wenigstens eine Ausnehmung, z.B. erzeugt durch Fräsen, in einer oder beiden von zwei separaten Wärmetauscherkomponenten, welche den ersten Wärmetauscher bilden. Die beiden Wärmetauscherkomponenten können derart geformt sein, dass beim Zusammensetzen der beiden Wärmetauscherkomponenten die Kältemittelleitung zwischen den beiden Wärmetauscherkomponenten ausgebildet wird. Dazu kann entweder eine der Wärmetauscherkomponenten oder beide Wärmetauscherkomponenten eine längliche Ausnehmung, ähnlich einer Nut, aufweisen, sodass beim Zusammensetzen ein bis auf die Enden geschlossener Kanal gebildet wird, welcher die Kältemittelleitung bildet.

In die Ausnehmung kann bevorzugt ein Rohr eingepresst werden, welches die Kältemittelleitung bildet.

Die Ausnehmung kann bevorzugt durch Fräsen hergestellt werden.

Die wenigstens eine Kältemittelleitung kann bevorzugt einen runden oder einen eckigen Querschnitt aufweisen. Entsprechend kann die Kältemittelleitung auch durch eine oder zwei Ausnehmungen mit einem eckigen oder einen runden bzw. halbrunden Querschnitt gebildet werden.

Bevorzugt ist die Kältemittelleitung an oder in dem Verdampferabschnitt angeordnet.

Bevorzugt ist die Kältemittelleitung eine Rohrleitung und in den Verdampferabschnitt integriert, insbesondere eingepresst. Durch die Integration der Kältemittelleitung in den Verdampferabschnitt entsteht vorteilhaft eine große Kontaktfläche zwischen dem Verdampferabschnitt und den Kältemittelleitungen, welche die Effizienz der Wärmeübertragung vorteilhaft erhöht. Der Verdampferabschnitt weist bevorzugt entsprechende Vertiefungen auf, in welche die Kältemittelleitungsabschnitte eingelassen sind.

Bevorzugt verlaufen die Kältemittelleitungen parallel zueinander. Bevorzugt erstrecken sich die parallel verlaufenden Kältemittelleitungen über den gesamten Verdampferabschnitt.

Bevorzugt sind erste Endabschnitte der Kältemittelleitungen mit einem ersten Sammelleitungsabschnitt verbunden.

Bevorzugt sind zweite Endabschnitte der Kältemittelleitungen mit einem zweiten Sammelleitungsabschnitt verbunden.

Bevorzugt kann eine einzige Kühlmittelleitung vorgesehen sein, welche sich mäanderförmig durch den Verdampferabschnitt erstreckt. Die durch die Mäanderform ausgebildeten Rohrbögen können sich dabei außerhalb des Verdampferabschnitts bzw. des Wärmetauschers erstrecken und somit frei liegen oder in dem Material des Verdampferabschnitts und somit innenliegend angeordnet sein.

Sind die Kältemittelleitungen nicht durch Rohrleitungen gebildet, sondern durch Bohrungen oder Ausnehmungen (wie Fräsungen) in dem Verdampferabschnitt, können Verbindungsleitungsabschnitte vorgesehen sein, welche zwischen den Bohrungsenden der Kältemittelleitungen und dem ersten bzw. zweiten Sammelleitungsabschnitt verlaufen und die Bohrungsenden mit den Sammelleitungsabschnitten fluidisch verbinden.

Bevorzugt kann der Kältemittelführungsabschnitt auch eine andere Form aufweisen und beispielsweise ein Plattenwärmetauscher sein oder eine beliebige andere Form aufweisen, welche eine effektive Wärmeübertragung von dem Verdampferabschnitt auf das Kältemittel ermöglicht.

Bevorzugt kann der erste Wärmetauscher als ein von dem Kältemittelkreis bzw. der Trennwand separates Bauteil bzw. eine separate Bauteileinheit ausgeführt sein. Dazu weist der zweite Wärmetauscher insbesondere Anschlüsse auf, um den ersten Wärmetauscher, insbesondere die Kältemittelleitungen, an den Kältemittelkreis anzuschließen.

Bevorzugt umfasst die Klimatisierungsanordnung eine thermische Isolationseinrichtung zum zumindest abschnittweise thermischen Isolieren des Verdampferabschnitts. Insbesondere ist die thermische Isolationseinrichtung in dem außenseitigen Gehäusebereich angeordnet. Durch die Isolationseinrichtung kann die Effektivität der Wärmeübertragung von dem Verdampferabschnitt auf das Kältemittel bzw. den Kältemittelkreis erhöht werden, da die Wärme nicht an die Luft in dem außenseitigen Gehäusebereich übertragen wird, sondern direkt an das Kältemittel, sodass die Wärme über den Kältemittelkreis effektiv an die Umgebung abgegeben werden kann da somit keine Wärme aus dem außenseitigen Gehäusebereich bzw. aus der Umgebung auf den Kältemittelkreis übertragen werden kann.

Darüber hinaus wird die erfindungsgemäße Aufgabe gelöst durch eine Klimatisierungsanordnung für einen Schaltschrank, umfassend ein Gehäuse mit einem schaltschrankseitigen Gehäusebereich und einem außenseitigen Gehäusebereich, umfassend eine zwischen dem schaltschrankseitigen Gehäusebereich und dem außenseitigen Gehäusebereich angeordnete Trennwand, welche den schaltschrankseitigen Gehäusebereich und den außenseitigen Gehäusebereich fluidisch voneinander trennt, und umfassend einen sich durch die Trennwand hindurcherstreckenden ersten Wärmetauscher, mit einem im schaltschrankseitigen Gehäusebereich angeordneten Verdampferabschnitt und einem mit dem Verdampferabschnitt thermisch gekoppelten, im außenseitigen Gehäusebereich angeordneten Wärmeaufnahmeabschnitt zur Aufnahme der Wärme aus dem außenseitigen Gehäusebereich und zur Weiterleitung der Wärme an den Verdampferabschnitt mittels Wärmeleitung, wobei im schaltschrankseitigen Gehäusebereich ein, insbesondere ein toxisches Kältemittel aufweisender, Kältemittelkreis angeordnet ist, derart, dass die an den Verdampferabschnitt weitergeleitete Wärme aus dem außenseitigen Gehäusebereich an den Kältemittelkreis übertragbar ist.

Die Klimatisierungsanordnung ist insbesondere eine Wärmepumpenanordnung zum Zuführen von Wärme aus der Umgebung in den schaltschrankseitigen Gehäusebereich. Dies ist insbesondere voreilhaft bei Anwendungssituationen, bei denen der Schaltschrank nicht gekühlt, sondern im Gegenteil beheizt werden sollte. Der Kältemittelkreis ist dabei im schaltschrankseitigen Gehäusebereich angeordnet. Insbesondere wenn ein toxisches Kältemittel verwendet wird, ist dies insoweit vorteilhaft, als dass im Fall einer Leckage das toxische Kältemittel im Schaltschrank bzw. im schaltschrankseitigen Gehäusebereich verbleibt und nicht über den außenseitigen Gehäusebereich nach außen dringen und Menschen gefährden kann.

Es kann ferner eine Klimatisierungsanordnung für einen Schaltschrank vorgesehen sein, umfassend ein Gehäuse mit einem schaltschrankseitigen Gehäusebereich und einem außenseitigen Gehäusebereich, umfassend eine zwischen dem schaltschrankseitigen Gehäusebereich und dem außenseitigen Gehäusebereich angeordnete Trennwand, welche den schaltschrankseitigen Gehäusebereich und den außenseitigen Gehäusebereich fluidisch voneinander trennt, und umfassend einen sich durch die Trennwand hindurcherstreckenden ersten Wärmetauscher, mit einem im schaltschrankseitigen Gehäusebereich angeordneten Verflüssigerabschnitt und einem mit dem Verflüssigerabschnitt thermisch gekoppelten, im außenseitigen Gehäusebereich angeordneten Wärmeaufnahmeabschnitt zur Aufnahme von Wärme von dem Verflüssigerabschnitt mittels Wärmeleitung und zur Abgabe der Wärme an den außenseitigen Gehäusebereich, wobei im schaltschrankseitigen Gehäusebereich ein, insbesondere ein toxisches Kältemittel aufweisender, Kältemittelkreis angeordnet ist, derart, dass die Wärme aus dem schaltschrankseitigen Gehäusebereich vom Kältemittelkreis an den Verflüssigerabschnitt übertragbar ist.

Die Klimatisierungsanordnung kühlt den Schaltschrank bzw. entzieht diesem Wärme und führt diese über den Wärmetauscher und den außenseitigen Gehäusebereich nach außen in die Umgebung ab. Der Kältemittelkreis ist dabei im schaltschrankseitigen Gehäusebereich angeordnet. Insbesondere wenn ein toxisches Kältemittel verwendet wird, ist dies insoweit vorteilhaft, als dass im Fall einer Leckage das toxische Kältemittel im Schaltschrank bzw. im schaltschrankseitigen Gehäusebereich verbleibt und nicht über den außenseitigen Gehäusebereich nach außen dringen und Menschen gefährden kann.

Die erfindungsgemäße Aufgabe wird ferner gelöst durch einen Schaltschrank aufweisend eine vorstehend beschriebene Klimatisierungsanordnung. Insbesondere kann das vorstehend beschriebene Gehäuse ein Gehäuse des Schaltschranks sein.

### Kurze Beschreibung der Figuren

Die Erfindung wird anhand der Figuren näher erläutert. Es zeigen:
- Fig. 1a: eine erste Schnittansicht durch einen Teil einer Klimatisierungsanordnung mit einer Kältemittelleitung gemäß einer ersten Ausführungsform,
- Fig. 1b: eine zweite Schnittansicht durch einen Teil einer Klimatisierungsanordnung mit der Kältemittelleitung gemäß der ersten Ausführungsform,
- Fig. 2a: eine erste Schnittansicht durch einen Teil einer Klimatisierungsanordnung mit einer Kältemittelleitung gemäß einer zweiten Ausführungsform,
- Fig. 2b: eine zweite Schnittansicht durch einen Teil einer Klimatisierungsanordnung mit der Kältemittelleitung gemäß der zweiten Ausführungsform,
- Fig. 3: eine perspektivische Ansicht eines ersten Wärmetauschers der Klimatisierungsanordnung mit der Kältemittelleitung gemäß der zweiten Ausführungsform,
- Fig. 4a, b: Schnittsichten des ersten Wärmetauschers der Klimatisierungsanordnung gemäß unterschiedlicher Ausführungsformen mit Rohrbögen,
- Fig. 5a, b: Schnittansichten des ersten Wärmetauschers der Klimatisierungsanordnung gemäß unterschiedlicher Ausführungsformen mit geradem Verlauf der Kältemittelleitungen,
- Fig. 6a, b, c: verschiedene Ausführungsformen eines Dichtungsbereichs zwischen einer Trennwand und dem ersten Wärmetauscher,
- Fig. 7a, b: verschiedene Ausführungsformen der Anordnung von Kältemittelleitungen in dem ersten Wärmetauscher,
- Fig. 8a-j: verschiedene Ausführungsformen der Ausgestaltung der Kältemittelleitungen in dem ersten Wärmetauscher, und
- Fig. 9: eine schematische Ansicht eines Gehäuses eines Schaltschranks mit der Klimatisierungsanordnung.

### Ausführliche Beschreibung der Figuren

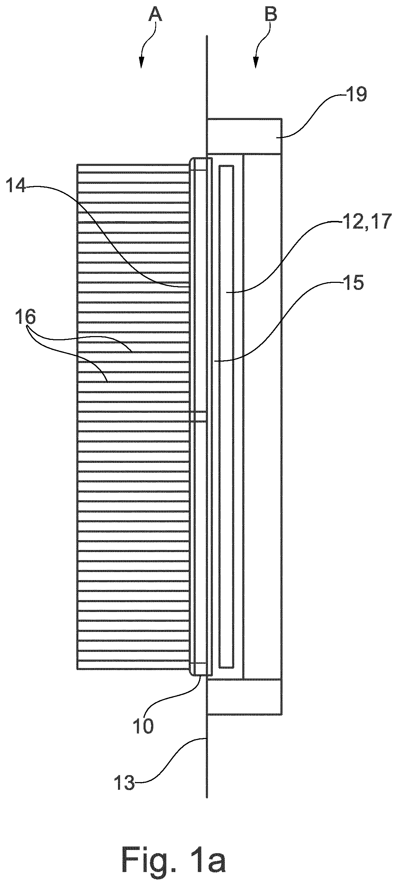

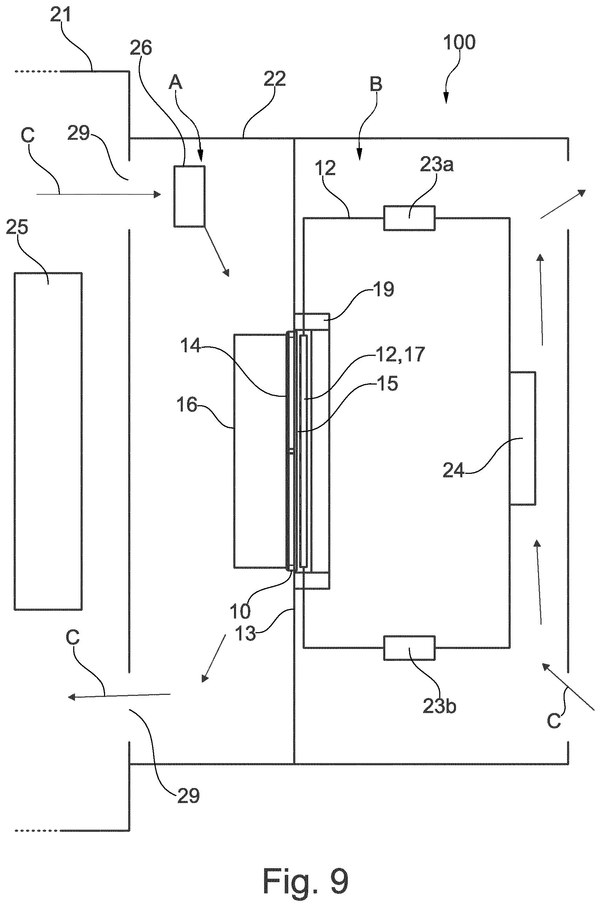

Figur 1a zeigt einen Teil einer Klimatisierungsanordnung 100 gemäß einer ersten Ausführungsform für einen nicht dargestellten Schaltschrank in einer ersten Schnittansicht entlang einer Strömungsrichtung der Kühlluft bzw. in Richtung einer Längserstreckung von Wärmeübertragungskörper 16 der Klimatisierungsanordnung, welche jeweils durch Kühlrippen gebildet werden, die parallel zueinander angeordnet sind. Die Strömungsrichtung der Kühlluft erfolgt in der gezeigten Darstellung von Fig. 1a in die Zeichnungsebene hinein und somit parallel zu und entlang der Kühlrippen. Die Klimatisierungsanordnung 100 ist an einem Schaltschrank 21 angeordnet und umfasst ein Gehäuse 22 (Fig. 9) mit einem schaltschrankseitigen Gehäusebereich A und einen außenseitigen Gehäusebereich B, wobei die beiden Gehäusebereiche A, B durch eine Trennwand 13 fluidisch voneinander getrennt sind, sodass insbesondere kein Kältemittel von dem außenseitigen Gehäusebereich B in den schaltschrankseitigen Gehäusebereich A gelangen kann.

Der schaltschrankseitige Gehäusebereich A ist angrenzend an den Schaltschrank 21 angeordnet, in dem wärmegenerierende, elektronische Komponenten 25 angeordnet sind. Der schaltschrankseitige Gehäusebereich A ist über Öffnungen 29 fluidisch mit dem Schaltschrank verbunden, d.h. warme Luft strömt vom Schaltschrank 21 in den schaltschrankseitigen Gehäusebereich A der Klimatisierungsanordnung 100 und nach erfolgter Wärmeübertragung strömt die abgekühlte Luft wieder zurück in den Schaltschrank (angedeutet durch die Strömungspfeile der Luft C) Zum Abführen der Wärme aus dem schaltschrankseitigen Gehäusebereich A ist ein erster Wärmetauscher 10 vorgesehen, welcher in der Trennwand 13 angeordnet ist. Der erste Wärmetauscher 10 ist insbesondere in einer Öffnung der Trennwand 13 angeordnet und erstreckt sich durch die Trennwand 13.

Der erste Wärmetauscher 10 ist plattenförmig ausgebildet mit einem Wärmeaufnahmeabschnitt 14 auf einer Seite des ersten Wärmetauschers 10, welche dem schaltschrankseitigen Gehäusebereich A zugewandt ist. Über den Wärmeaufnahmeabschnitt 14 erfolgt die Aufnahme der Wärme aus dem schaltschrankseitigen Gehäusebereich A über Wärmeübertragungskörper 16 in Form von Kühlrippen, welche sich in den schaltschrankseitigen Gehäusebereich A erstrecken und vorzugsweise parallel zur Strömungsrichtung der Luft angeordnet sind.

Mittels Wärmeleitung wird die Wärme an einen Verdampferabschnitt 15 des ersten Wärmetauschers 10 mittels Wärmeleitung weitergeleitet, wobei der Verdampferabschnitt 15 an einer dem außenseitigen Gehäusebereich B zugewandten Seite des Wärmetauschers 10 angeordnet ist bzw. diese Seite des ersten Wärmetauschers 10 bildet. Der Wärmeaufnahmeabschnitt 14 und der Verdampferabschnitt 15 sind Bestandteil eines einzigen plattenförmigen Elements.

Über den Verdampferabschnitt 15 wird die Wärme an einen Kältemittelkreis 12 in dem außenseitigen Gehäusebereich B abgegeben. Der Kältemittelkreis 12 umfasst Kältemittelleitungsabschnitte 17, welche in dem Verdampferabschnitt 15 angeordnet sind bzw. durch den Verdampferabschnitt 15 hindurch verlaufen. Die Kältemittelleitungsabschnitte 17 verlaufen gemäß dieser ersten Ausführungsform quer zu einer Längserstreckung der Kühlrippen angeordnet. Mit anderen Worten sind die Kühlrippen und die Kältemittelleitungsabschnitte 17 gekreuzt zueinander geführt. Die Wärme wird von dem Verdampferabschnitt 15 an das Kältemittel in den Kältemittelleitungsabschnitten 17 übertragen. Das erwärmte Kältemittel wird in dem Kältemittelkreis 12 weiter transportiert und die Wärme über den Kältemittelkreis 12 bzw. dessen weiteren Komponenten, wie etwa weitere Wärmetauscher, an die Umgebung abgegeben.

Ferner weist die Klimatisierungsanordnung eine Isolationseinrichtung 19 auf, welche den Verdampferabschnitt 15 und einen Bereich des Kältemittelkreises 12, an welchem die Wärmeübertragung von dem Verdampferabschnitt 15 an das Kältemittel im Kältemittelkreis 12 erfolgt, umgibt. Insbesondere umgibt die Isolationseinrichtung 19 den Verdampferabschnitt 15 und die durch den Verdampferabschnitt 15 verlaufenden Kältemittelleitungsabschnitte 17.

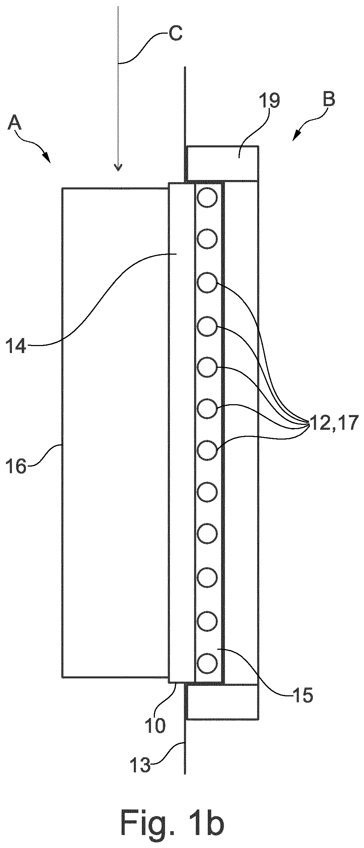

Figur 1b zeigt die Klimatisierungsanordnung 100 gemäß der ersten Ausführungsform in einer zweiten Schnittansicht entlang einer Längserstreckung der Kältemittelleitungen 17 und parallel zur Längserstreckung der Kühlrippen. Die Schnittachse der Schnittansicht der Fig. 1b ist daher gegenüber der Schnittachse der Schnittansicht aus Fig. 1a um 90° gedreht. Die Strömungsrichtung C der Kühlluft im schaltschrankseitige Gehäusebereich A verläuft in der Ansicht aus Fig. 1b von oben nach unten, so das die Kühlluft zwischen den Kühlrippen hindurch strömen kann. Ansonsten sind die zweite und die erste Ausführungsform im Wesentliche gleich ausgebildet, so das die vorstehenden Ausführungen zur ersten Ausführungsform analog auch für die zweite Ausführungsform gelten.

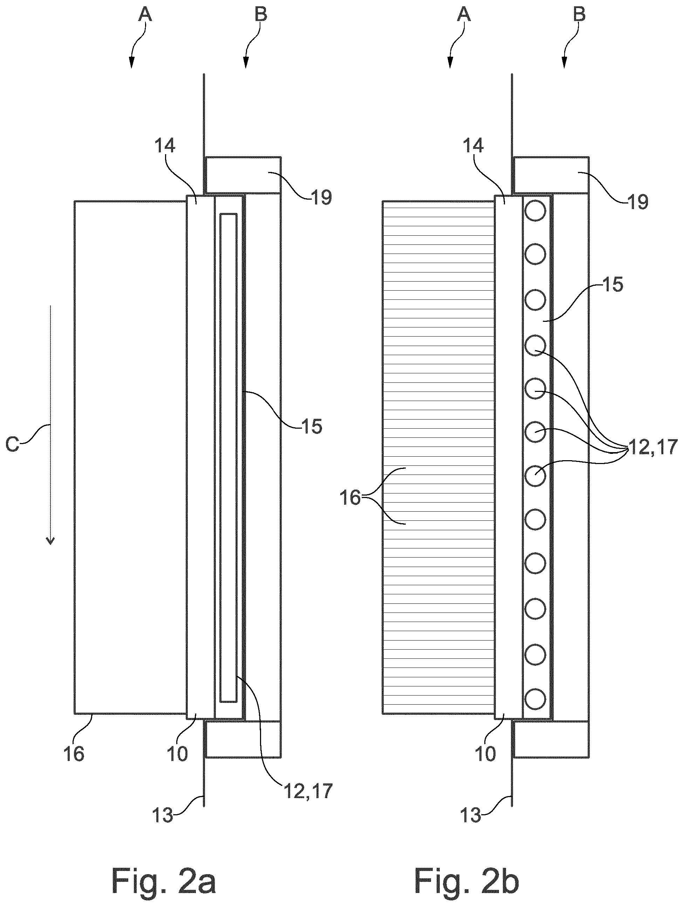

Figuren 2a und 2b zeigen zwei Schnittansichten der Klimatisierungsanordnung 100 gemäß einer zweiten Ausführungsform, welche sich von der in den Figuren 1a und 1b gezeigten Ausführungsform in der Anordnung der Kühlrippen relativ zu den Kältemittelleitungen 17 unterscheidet. Hier verlaufen die Kältemittelleitungen 17 parallel zu einer Längserstreckung der Kühlrippen, welche die Wärmeübertragungskörper 16 bilden. Mit anderen Worten sind die Kühlrippen und die Kältemittelleitungsabschnitte 17 parallel zueinander geführt.

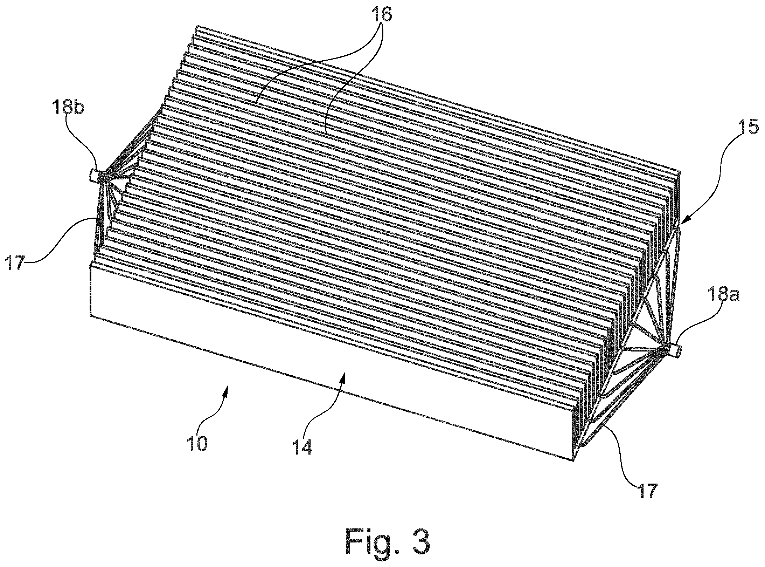

Figur 3 zeigt eine perspektivische Ansicht des ersten Wärmetauschers 10. Der erste Wärmetauscher 10 weist mehrere Wärmeübertragungskörper 16 in Form von Kühlrippen auf, welche sich über den gesamten Wärmeaufnahmeabschnitt 14 des ersten Wärmetauschers 10 parallel zueinander erstrecken. Insbesondere stehen die Wärmeübertragungskörper 16 senkrecht von dem Wärmeaufnahmeabschnitt 14 hervor.

Ferner sind in Figur 3 eine Vielzahl von Kältemittelleitungsabschnitten 17 gezeigt, welche sich durch den Verdampferabschnitt 15 des ersten Wärmetauschers 10 gemäß der zweiten Ausführungsform erstrecken. An zwei sich gegenüberliegenden Enden des Verdampferabschnitts 15 werden die Kältemittelleitungsabschnitte 17 jeweils in einem ersten Sammelleitungsabschnitt 18a und einem zweiten Sammelleitungsabschnitt 18b zusammengeführt, sodass das Kältemittel aus den Kältemittelleitungsabschnitten 17 dem weiteren Verlauf des Kältemittelkreises 12 zugeführt werden kann. Wie in der Figur 2 dargestellt, kann der erste Wärmetauscher mit den Kältemittelleitungsabschnitten 17 als ein separates Bauteil bzw. eine Bauteileinheit ausgebildet sein. Die Kühlrippen und die Kältemittelleitungsabschnitte 17 sind parallel zueinander geführt, so dass diese Anordnung derjenigen aus den Fig. 2a und 2b entspricht.

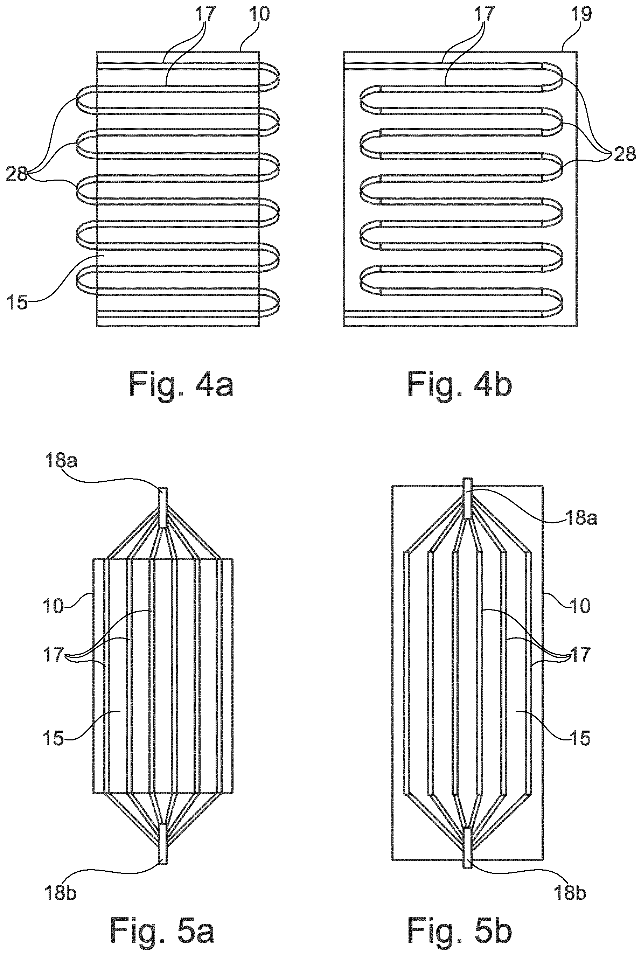

Figuren 4a und 4b zeigen Schnittansichten des Verdampferabschnitts 15 des ersten Wärmetauschers 10 gemäß unterschiedlicher Ausführungsformen. Dargestellt ist der mäanderförmige Verlauf einer Kältemittelleitung 17 des Kältemittelkreises 12. Die Kältemittelleitung 17 umfasst Rohrbögen 28, welcher in dem in Figuren 4a dargestellten Ausführungsbeispiel außerhalb des Verdampferabschnitts 15 angeordnet sind, während die Rohrbögen in dem Ausführungsbeispiel der Figur 4b innerhalb des Verdampferabschnitts 15 verlaufen.

Figuren 5a und 5b zeigen Schnittansichten des Verdampferabschnitts 15 des ersten Wärmetauschers 10 gemäß unterschiedlicher Ausführungsformen, wobei die Kältemittelleitungen 17 einen geraden Verlauf zwischen zwei Sammelleitungsabschnitten 18a, 18b aufweisen. In Figur 5a sind die Sammelleitungsabschnitte 18a, 18b außerhalb des Verdampferabschnitts 15 angeordnet, während die Sammelleitungsabschnitte 18a, 18b in dem in Figur 5b gezeigten Ausführungsbeispiel innerhalb des Verdampferabschnitts 15 verlaufen.

Grundsätzlich sind auch Kombinationen der Ausführungsformen aus Fig. 4a und 4b und den Ausführungsformen aus den Fig. 5a und 5b möglich. Zum Beispiel könnten verschiedene mäandernde Kältemittelleitungen ein gemeinsame Sammelleitungsabschnitte münden.

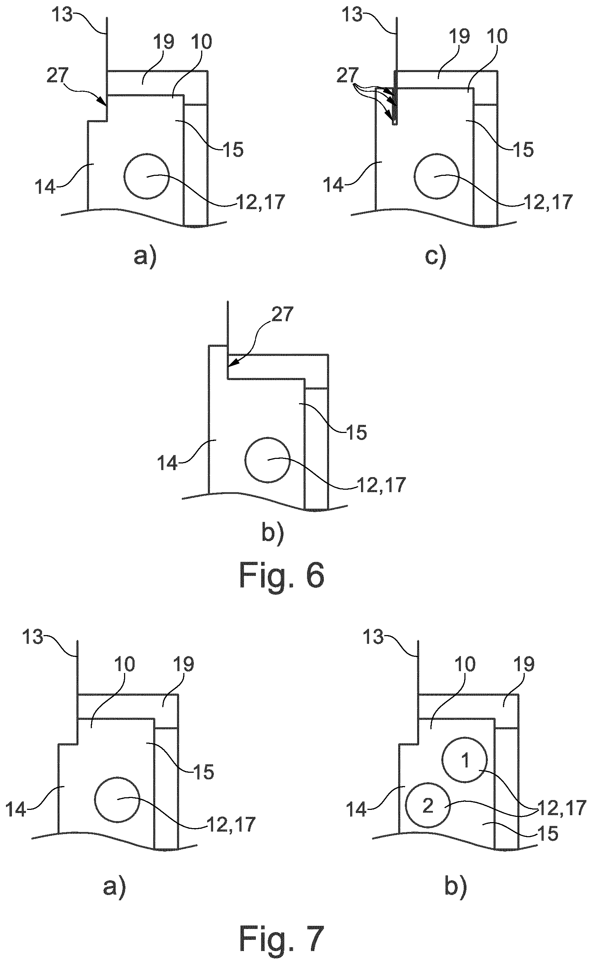

Figuren 6 a - c zeigen unterschiedliche Ausgestaltungsformen eines Dichtbereichs 27 zwischen dem ersten Wärmetauscher 10 und der Trennwand 13.

Wie in Figur 6a gezeigt kann der erste Wärmetauscher 10 eine stufenförmige Ausnehmung an einer der Trennwand 13 zugewandten Kante aufweisen, sodass eine zum schaltschrankseitigen Gehäusebereich A gerichtete Dichtfläche im Bereich der Ausnehmung gebildet wird, an welcher die Trennwand 13 anliegt.

In der Ausführungsform gemäß Figur 6b ist die Ausnehmung mit der Dichtfläche dem umgebungsseitigen Gehäusebereich B zugewandt.

In der in Figur 6c gezeigten Ausführungsform weist der erste Wärmetauscher 10 eine schlitzförmige Vertiefung auf, deren Innenwände die Dichtflächen bilden. Die Trennwand 13 erstreckt sich in die schlitzförmige Vertiefung hinein.

Figuren 7a und 7b zeigen Querschnittsansichten durch einen Bereich des ersten Wärmetauschers 10, welche die Anordnung der Kältemittelleitungen 17 zeigen. In Figur 7a verlaufen die Kältemittelleitungen 17 in einer Ebene während die Kältemittelleitungen 17 in der in Figur 7b gezeigten Ausführungsform in zwei Ebenen angeordnet sind.

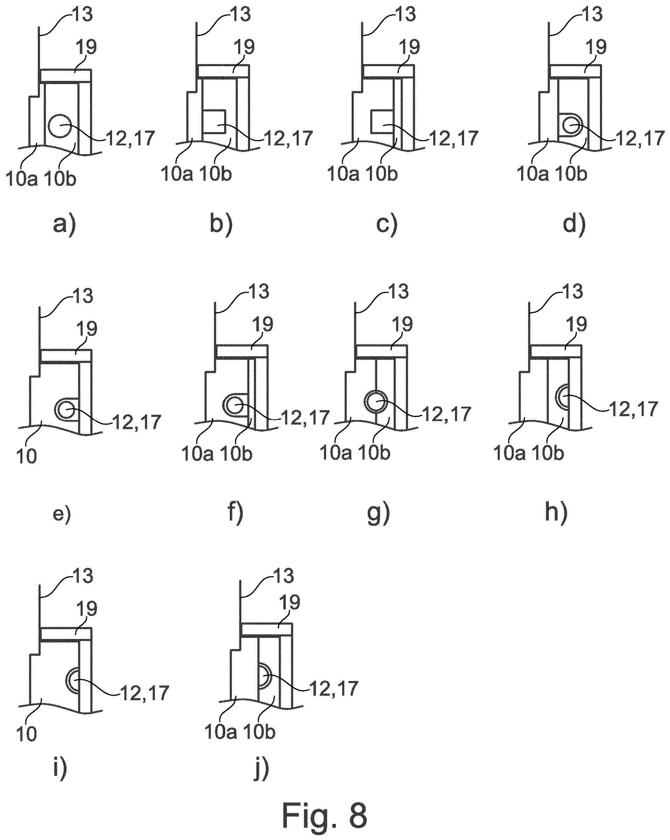

Figuren 8a bis 8j zeigen verschiedene Möglichkeiten der Ausbildung einer Kältemittelleitung in dem ersten Wärmetauscher 10.

Mit Ausnahme der Figuren 8e und 8i ist der erste Wärmetauscher 10 durch zwei Wärmetauscherkomponenten 10a, 10b gebildet. In Figur 8a ist die Kältemittelleitung 17 durch eine Bohrung in einer der beiden Wärmetauscherkomponenten 10b gebildet.

In den Figuren 8b, 8c, 8d, 8f, 8g und 8j ist jeweils eine eckige oder runde bzw. halbrunde Ausnehmung in einer oder beiden der Wärmetauscherkomponenten 10a, 10b eingebracht, wobei entweder die Ausnehmung als solche die Kältemittelleitung 17 bildet (Figuren 8b, 8c) oder wobei in die Ausnehmung Rohre bzw. Flachrohre eingepresst sind, welche die Kältemittelleitung 17 bilden (Figuren 8d, Figuren 8f bis 8h und Figur 8j). Wenn nur in eine der beiden Wärmetauscherkomponenten 10a, 10b eine Ausnehmung eingebracht wird (Figuren 8b, 8c, 8d, 8f, 8j), stellt die jeweils andere Wärmetauscherkomponente 10a, 10b ohne Ausnehmung ein deckelartiges Element dar. Die Ausnehmungen können einen eckigen Querschnitt aufweisen (Figuren 8b und 8c) und in eine der Wärmetauscherkomponenten 10a, 10b eingefräst sein. Auch die runden Ausnehmungen (Figuren 8d bis 8j) können durch Fräsen hergestellt werden.

Figur 9 zeigt die Klimatisierungsanordnung 100, welche an einem Schaltschrank 21 angeordnet ist. Insbesondere ist die Klimatisierungsanordnung 100 an einem Schaltschrankgehäuse angeordnet und durch eine obere und eine untere Öffnung 29 in dem Schaltschrankgehäuse kann Luft aus dem Schaltschrank 21, in dem sich wenigstens eine elektrische Komponente 25 befindet, in den schaltschrankseitigen Gehäusebereich A gelangen, dort durch den ersten Wärmetauscher gekühlt und durch eine untere Öffnung wieder dem Inneren des Schaltschranks 21 zugeführt werden. Dies ist durch Pfeile C in der Figur 9 entsprechend angedeutet. Zum Fördern der Luft in diesem Bereich ist ein Lüfter 26 vorgesehen. Die Klimatisierungsanordnung 100 umfasst ein Gehäuse 22 mit dem schaltschrankseitigen Gehäusebereich A und dem umgebungsseitigen Gehäusebereich B, welche durch die Trennwand 13 voneinander getrennt sind. In der Trennwand 13 bzw. einem Ausschnitt der Trennwand 13 ist der erste Wärmetauscher 10 der Klimatisierungsanordnung 100 angeordnet, wobei die Dimensionen des ersten Wärmetauschers 10 an den Ausschnitt in der Trennwand 13 angepasst sind, sodass der erste Wärmetauscher 10 möglichst dicht und ohne Lücken in die Trennwand 13 eingepasst ist. Die als Kühlrippen ausgebildeten Wärmeübertragungskörper 16 verlaufen in der Darstellung der Fig. 9 parallel zu den Kältemittelleitungen 17. Bevorzugt können im Randbereich des Ausschnitts der Trennwand Abdichtmittel oder dergleichen vorgesehen sein, um die fluidische Dichtigkeit der Trennwand 13 auch mit eingesetztem Wärmetauscher 10 zu gewährleisten.

Der erste Wärmetauscher 10 nimmt die Wärme aus dem schaltschrankseitigen Gehäusebereich A auf und leitet diese an den Kältemittelkreis 12 in dem umgebungsseitigen Gehäusebereich B weiter. Der Kältemittelkreis 12 umfasst Komponenten 23a, 23b eines herkömmlichen Kältemittelkreislaufs wie etwa Verdichter, Expansionsorgane, etc. Grundsätzlich kann der Kältemittelkreis 12 mehr als die zwei dargestellten Komponenten 23a, 23b umfassen. Ferner umfasst der Kältemittelkreis 12 einen zweiten Wärmetauscher 24, insbesondere einen Verflüssiger, über welchen die Wärme von dem Kältemittel an die Umgebung abgegeben werden kann, wie durch die Pfeile in der Figur 3 angedeutet. Zum Zuführen und Abführen von Luft aus bzw. in die Umgebung sind entsprechende obere und untere Öffnungen in dem Gehäuse 22 in dem außenseitigen Gehäusebereich B vorgesehen. Zum Fördern der Luft in diesem Bereich können hier nicht dargestellte Lüfter an den Öffnungen vorgesehen sein.

### Liste der Bezugszeichen

- 100: Klimatisierungsanordnung

- 10: erster Wärmetauscher
- 10a, b: Wärmetauscherkomponenten
- 12: Kältemittelkreis
- 13: Trennwand
- 14: Wärmeaufnahmeabschnitt
- 15: Verdampferabschnitt
- 16: Wärmeübertragungskörper
- 17: Kältemittelleitungen
- 18a: erster Sammelleitungsabschnitt
- 18b: zweiter Sammelleitungsabschnitt
- 19: Isolationseinrichtung

- 20: Anschlüsse
- 21: Schaltschrank
- 22: Gehäuse
- 23a, b: Komponenten des Kältemittelkreises
- 24: zweiter Wärmetauscher
- 25: elektronische Komponente
- 26: Lüfter
- 27: Dichtbereich
- 28: Rohrbögen
- 29: Öffnungen

- A: schaltschrankseitiger Gehäusebereich
- B: außenseitiger Gehäusebereich
- C: Strömungsrichtung Luft

## Patentansprüche

1. Klimatisierungsanordnung (100) für einen Schaltschrank (21), umfassend ein Gehäuse (22) mit einem schaltschrankseitigen Gehäusebereich (A) und einem außenseitigen Gehäusebereich (B), umfassend eine zwischen dem schaltschrankseitigen Gehäusebereich (A) und dem außenseitigen Gehäusebereich (B) angeordnete Trennwand (13), welche den schaltschrankseitigen Gehäusebereich (A) und den außenseitigen Gehäusebereich (B) fluidisch voneinander trennt, und umfassend
einen sich durch die Trennwand (13) hindurcherstreckenden ersten Wärmetauscher (10), wobei der erste Wärmetauscher (10) ein Luft-Flüssigkeits-Wärmetauscher ist, mit einem im außenseitigen Gehäusebereich (B) angeordneten Verdampferabschnitt (15) und einem mit dem Verdampferabschnitt (15) thermisch gekoppelten, im schaltschrankseitigen Gehäusebereich (A) angeordneten Wärmeaufnahmeabschnitt (14) zur Aufnahme der Wärme aus dem schaltschrankseitigen Gehäusebereich (A) und zur Weiterleitung der Wärme an den Verdampferabschnitt (15) mittels Wärmeleitung, wobei im außenseitigen Gehäusebereich (B) ein, insbesondere ein brennbares und/oder toxisches Kältemittel aufweisender, Kältemittelkreis (12) angeordnet ist, derart, dass die an den Verdampferabschnitt (15) weitergeleitete Wärme aus dem schaltschrankseitigen Gehäusebereich (A) an den Kältemittelkreis übertragbar ist.

2. Klimatisierungsanordnung (100) nach Anspruch 1, wobei der Verdampferabschnitt (15) und der Wärmeaufnahmeabschnitt (14) einstückig ausgebildet sind.

3. Klimatisierungsanordnung (100) nach einem der vorgenannten Ansprüche, wobei der erste Wärmetauscher (10) in einer Öffnung in der Trennwand angeordnet (13) ist, wobei der erste Wärmetauscher (10) die Öffnung, insbesondere fluidisch, dicht abschließt.

4. Klimatisierungsanordnung (100) nach einem der vorgenannten Ansprüche, wobei der Wärmeaufnahmeabschnitt (14) und/oder der Verdampferabschnitt (15) durch einen flächigen Abschnitt eines Grundkörpers des ersten Wärmetauschers (10) gebildet ist bzw. sind, wobei sich der flächige Abschnitt über im Wesentlichen eine gesamte Öffnungsfläche einer Öffnung in der Trennwand (13) erstreckt.

5. Klimatisierungsanordnung (100) nach Anspruch 4, wobei der Grundkörper des ersten Wärmetauschers (10) im Wesentlichen plattenförmig ausgebildet ist, wobei sich der Grundkörper des ersten Wärmetauschers (10) bevorzugt im Wesentlichen parallel zur Trennwand (13) erstreckt.

6. Klimatisierungsanordnung (100) nach einem der Ansprüche 4 oder 5, wobei eine erste Seite des Grundkörpers des ersten Wärmetauschers (10) den Wärmeaufnahmeabschnitt (14) bildet und zum schaltschrankseitigen (A) Gehäusebereich hin orientiert ist.

7. Klimatisierungsanordnung (100) nach einem der vorgenannten Ansprüche, wobei eine zweite, der ersten Seite des Grundkörpers des ersten Wärmetauschers (10) gegenüberliegende Seite des ersten Wärmetauschers (10) den Verdampferabschnitt (15) bildet und zum außenseitigen Gehäusebereich (B) hin orientiert ist.

8. Klimatisierungsanordnung (100) nach einem der vorgenannten Ansprüche, wobei der erste Wärmetauscher (10) an dem Wärmeaufnahmeabschnitt (14) eine Vielzahl von Wärmeübertragungskörpern (16), insbesondere Kühlrippen, aufweist, welche sich in den schaltschrankseitigen Gehäusebereich (A) hinein erstrecken.

9. Klimatisierungsanordnung (100) nach einem der vorgenannten Ansprüche, wobei der Kältemittelkreislauf (12) ausschließlich in dem außenseitigen Gehäusebereich (B) angeordnet ist, und/oder wobei der Kältemittelkreislauf (12) Propan als Kältemittel umfasst.

10. Klimatisierungsanordnung (100) nach Anspruch 9, wobei der Verdampferabschnitt (15) einen Kältemittelführungsabschnitt umfasst, wobei der Kältemittelführungsabschnitt thermisch mit dem Wärmeaufnahmeabschnitt (14) des ersten Wärmetauschers (10) gekoppelt ist, wobei der Kältemittelführungsabschnitt bevorzugt wenigstens eine Kältemittelleitung (17) umfasst oder ist, wobei der Kältemittelführungsabschnitt bevorzugt eine Vielzahl von Kältemittelleitungen (17) aufweist.

11. Klimatisierungsanordnung (100) nach Anspruch 10, wobei die Kältemittelleitung (17) an dem Verdampferabschnitt (15) angeordnet ist, wobei die Kältemittelleitung bevorzugt (17) in den Verdampferabschnitt (15) integriert, insbesondere eingepresst, ist.

12. Klimatisierungsanordnung (100) nach einem der Ansprüche 10 oder 11, wobei der Kältemittelführungsabschnitt eine Vielzahl an parallel zueinander verlaufenden Kältemittelleitungen (17) aufweist, welche thermisch mit dem Verdampferabschnitt (15) gekoppelt sind, wobei erste Endabschnitte der Kältemittelleitungen (17) bevorzugt mit einem erstem Sammelleitungsabschnitt (18a) verbunden sind, und/oder wobei zweite Endabschnitte der Kältemittelleitungen (17) mit einem zweiten Sammelleitungsabschnitt (18b) verbunden sind.

13. Klimatisierungsanordnung (100) nach einem der vorgenannten Ansprüche, umfassend eine thermische Isolationseinrichtung (19) zum zumindest abschnittsweise thermischen Isolieren des Verdampferabschnitts (15).

14. Klimatisierungsanordnung (100) für einen Schaltschrank (21), umfassend ein Gehäuse (22) mit einem schaltschrankseitigen Gehäusebereich (A) und einem außenseitigen Gehäusebereich (B), umfassend eine zwischen dem schaltschrankseitigen Gehäusebereich (A) und dem außenseitigen Gehäusebereich (B) angeordnete Trennwand (13), welche den schaltschrankseitigen Gehäusebereich (A) und den außenseitigen Gehäusebereich (B) fluidisch voneinander trennt, und umfassend
einen sich durch die Trennwand (13) hindurcherstreckenden ersten Wärmetauscher (10), mit einem im schaltschrankseitigen Gehäusebereich (A) angeordneten Verdampferabschnitt (15) und einem mit dem Verdampferabschnitt (15) thermisch gekoppelten, im außenseitigen Gehäusebereich (B) angeordneten Wärmeaufnahmeabschnitt (14) zur Aufnahme der Wärme aus dem außenseitigen Gehäusebereich (B) und zur Weiterleitung der Wärme an den Verdampferabschnitt (15) mittels Wärmeleitung, wobei im schaltschrankseitigen Gehäusebereich (A) ein, insbesondere ein toxisches Kältemittel aufweisender, Kältemittelkreis (12) angeordnet ist, derart, dass die an den Verdampferabschnitt (15) weitergeleitete Wärme aus dem außenseitigen Gehäusebereich (B) an den Kältemittelkreis übertragbar ist.

15. Schaltschrank, aufweisend eine Klimatisierungsanordnung (100) nach einem der vorgenannten Ansprüche.
